# EUROPEAN PATENT APPLICATION

(11) **EP 4 407 781 A1**
(43) Date of publication of application: **31.07.2024**
(21) Application number: 23857581.5
(22) Date of filing: 21.07.2023
(51) Int. Cl.: H01M 50/569, H01M 10/48, H01M 10/052, H01M 10/42

(54) **POWER SUPPLY DEVICE**

(30) Priority: 25.08.2022 KR 20220106846
(71) Applicant: LG Energy Solution, Ltd., Seoul 07335 (KR)
(72) Inventor: LEE, Solnip, Daejeon 34122 (KR)
(74) Representative: Goddar, Heinz J.
(86) International application number: PCT/KR2023/010596
(87) International publication number: WO 2024/043545

(57) **Abstract**

The present invention relates to a power supply device, and the purpose of the present invention is to provide a device for supplying power by using a secondary battery, which can stably supply power by monitoring the state of the secondary battery in real time.

## Description

### Technical Field

The present application claims the benefit of priority based on Korean Patent Application No. 10-2022-0106846 filed on August 25, 2022, the entire disclosure of which is incorporated as a part of this specification.

The present disclosure relates to a power supply device, and particularly to a power supply device capable of stably supplying power by monitoring the state of a secondary battery in real time in a device for supplying power using the secondary battery.

### Background Art

In general, a secondary battery is a battery which can be used repeatedly through a discharging process in which chemical energy is converted into electrical energy and a charging process in the opposite direction to the discharging process and the types of secondary batteries include nickel-cadmium (Ni-Cd) batteries, nickel-metal hydride (Ni-MH) batteries, lithium-metal batteries, lithium-ion (Li-ion) batteries, and lithium-ion polymer batteries. Among these secondary batteries, lithium secondary batteries having high energy density and voltage, long cycle life, and a low self-discharge rate have been commercialized and widely used.

As described above, since secondary batteries are easy to store electrical energy into chemical energy or convert chemical energy into electrical energy, they may be used in power supply and storage devices used in systems such as mobile devices such as electric vehicles or smart grids.

At this time, the state of the secondary battery affects the efficiency and function of a device or system to which the secondary battery is applied, and is directly related to user safety, especially when applied to an electric vehicle.

Therefore, it is very important to grasp the state of the secondary battery in real time in a device that supplies power by the secondary battery.

One of methods for monitoring the state of the secondary battery in real time may include a three-electrode system.

Specifically, a three-electrode analysis system using a reference electrode may be utilized for monitoring cathode/anode of a secondary battery. In a conventional three-electrode system, a thin copper wire coated with an LTO (Li4Ti5O12) active material is used as a reference electrode.

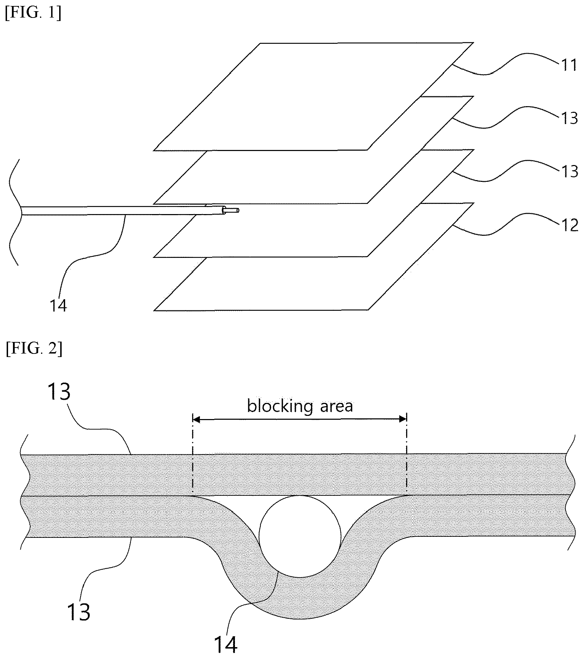

Specifically, as shown in FIG. 1, in the three-electrode battery, a Cu wire coated with an LTO active material may be inserted as a reference electrode 14 into a separator 13 stacked between a cathode 11 and an anode 12. More specifically, the separator 13 between the cathode 11 and the anode 12 is provided in two layers, and the reference electrode 14 may be located between the two layers of the separator 13.

At this time, when a wire-type reference electrode is used, as shown in FIG. 2, a blocking area is generated due to the shape of the reference electrode 14, and thus an unreacted area is formed, which may cause deterioration in the performance of the secondary battery.

Depending on the stiffness or thickness of the electrode itself, the size of the blocking area may be enlarged and become a problem, and in particular, when the pressure increases in the area where the reference electrode is located due to the increase in the internal pressure of the battery due to the increase in the thickness of the electrode and the generation of gas generated while the battery is operating, it causes damage to electrodes and separators, and may cause performance degradation and safety problems of a device or system to which a secondary battery-based power supply device is applied.

### Disclosure of the Invention

### Technical Goals

The present disclosure relates to a power supply device, and is to provide a power supply device capable of stably supplying power by monitoring the state of a secondary battery in real time in a device for supplying power using the secondary battery.

Technical objects to be achieved by the present disclosure are not limited to the technical objects mentioned above, and other technical objects not mentioned will be clearly understood by those skilled in the art from the description below.

### Technical Solutions

A power supply device of the present disclosure may include:
a battery module provided with a plurality of secondary batteries; and
a battery management system (BMS) unit configured to control the battery module,
wherein at least one of the plurality of secondary batteries may be provided as a three-electrode battery equipped with a reference electrode, and
wherein the reference electrode of the three-electrode battery may be provided in a film shape in which a plurality of perforated holes are formed.

### Advantageous Effects

A power supply device of the present disclosure may be capable of monitoring the state of a secondary battery in real time by including a three-electrode battery which may be stably driven even when used for a long time or for multiple cycles.

The three-electrode battery in the power supply device of the present disclosure may minimize the area of the blocking area due to the reference electrode, and suppress the occurrence of circuit problems such as internal short circuit or electrode damage such as electrode pitting due to changes in battery internal pressure.

The three-electrode battery in the power supply device of the present disclosure may be capable of highly reliable monitoring of cathode/anode regardless of the electrode's own physical properties and whether or not it is driven.

The three-electrode battery in the power supply device of the present disclosure may be a Si/SiO battery with a large thickness change, or a monitoring for long-term deterioration may be advantageous for it.

In the three-electrode battery in the power supply device of the present disclosure, the effect of reducing the three-electrode deviation may be expected due to the reduction of the blocking area.

The three-electrode battery in the power supply device of the present disclosure has a structure that facilitates design of a medium or large-sized battery, and may be applied regardless of the stack or area of the electrode

### Brief Description of Drawings

FIG. 1 is a schematic diagram illustrating a conventional three-electrode battery.
FIG. 2 is a cross-sectional view illustrating a conventional three-electrode battery.
FIG. 3 is a block diagram illustrating a power supply device of the present disclosure.
FIG. 4 is a cross-sectional view illustrating a three-electrode battery.
FIG. 5 is an exploded perspective view illustrating a stacked structure of a three-electrode battery.
FIG. 6 is a plan view illustrating an arrangement relationship between a first electrode and a reference electrode.
FIG. 7 is a graph illustrating battery characteristics according to an open ratio of a first area.
FIGS. 8A to 8C are photographs, each of which shows a state of a battery electrode according to a reference electrode.
FIG. 9 is a graph illustrating charging depth at 1C charge and 2C charge.
FIG. 10 is a block diagram illustrating another embodiment of a power supply device of the present disclosure.

### Best Mode for Carrying Out the Invention

A power supply device of the present disclosure may include:
a battery module provided with a plurality of secondary batteries; and
a battery management system (BMS) unit configured to control the battery module,
wherein at least one of the plurality of secondary batteries may be provided as a three-electrode battery equipped with a reference electrode, and
wherein the reference electrode of the three-electrode battery may be provided in a film shape in which a plurality of perforated holes are formed.

In the power supply device of the present disclosure, the three-electrode battery may include a main separator; the reference electrode in the film shape stacked on one side surface of the main separator; an auxiliary separator stacked on the one side surface of the main separator with the reference electrode interposed therebetween; a first electrode and a second electrode stacked with the main separator, the reference electrode, and the auxiliary separator interposed therebetween; and a battery case in which the main separator, the reference electrode, the auxiliary separator, the first electrode, and the second electrode are accommodated in an inner space, wherein the reference electrode may be provided with a thickness of 45 µm to 120 µm.

In the power supply device of the present disclosure, the reference electrode may include a first area facing the first electrode or the second electrode, and a second area protruding from one side of the first electrode or the second electrode, wherein the plurality of perforated holes may be formed in the first area, and an open ratio formed by the plurality of perforated holes in the first area may be 30% to 70%.

The three-electrode battery of the power supply device of the present disclosure may further include a reference electrode lead having one end fused to the second area of the reference electrode and the other end protruding out of the battery case.

In the power supply device of the present disclosure, an area of the first area may be provided as 1% to 10% of an area of the first electrode or the second electrode.

In the power supply device of the present disclosure, the reference electrode may include a foil member forming a body, and a reference electrode active material coated on the foil member.

In the power supply device of the present disclosure, a material of the foil member may include at least one of Cu-foil and Al-foil.

In the power supply device of the present disclosure, the reference electrode active material may be selected from a group consisting of LTO (Li4Ti5O12), LFP (LiFePO4), Li metal, and combinations thereof.

The power supply device of the present disclosure may further include:
a first voltage measuring unit configured to measure a voltage between the reference electrode and the first electrode or the second electrode; and
a second voltage measuring unit configured to measure a voltage between the first electrode and the second electrode,
wherein measured values of the first voltage measuring unit and the second voltage measuring unit may be transferred to the BMS unit.

The power supply device of the present disclosure may further include:
a first voltage measuring unit configured to measure a voltage between the reference electrode and the first electrode or the second electrode; and
a second voltage measuring unit configured to measure a voltage of the battery module,
wherein measured values of the first voltage measuring unit and the second voltage measuring unit may be transferred to the BMS unit.

In the power supply device of the present disclosure, a plurality of the battery modules may be provided, wherein each of the plurality of battery modules may be provided with at least one or more three-electrode batteries, a plurality of the first voltage measuring units may be provided, and a plurality of the second voltage measuring unit may be provided, and wherein each of the plurality of battery modules may be provided with at least one or more of the first voltage measuring units and at least one or more of the second voltage measuring units.

### Modes for Carrying Out the Invention

Hereinafter, embodiments according to the present disclosure will be described in detail with reference to the accompanying drawings. In this process, the size or shape of the components shown in the drawings may be exaggerated for clarity and convenience of explanation. In addition, terms specifically defined in consideration of the configuration and operation of the present disclosure may vary according to the intentions or customs of users and operators. Definitions of these terms should be made based on the content throughout this specification.

In the description of the present disclosure, it should be noted that the orientation or positional relationship indicated by the terms "center", "upper", "lower", "left", "right", "vertical", "horizontal", "inner side", "outer side", "one surface", "other surface" is based on the orientation or positional relationship shown in the drawing or the orientation or positional relationship normally arranged when using the product of the present disclosure, and it is intended only for explanation and brief description of the present disclosure, and is not to be construed as limiting the present disclosure as it does not suggest or imply that the device or element shown must necessarily be configured or operated in a specific orientation with a specific orientation.

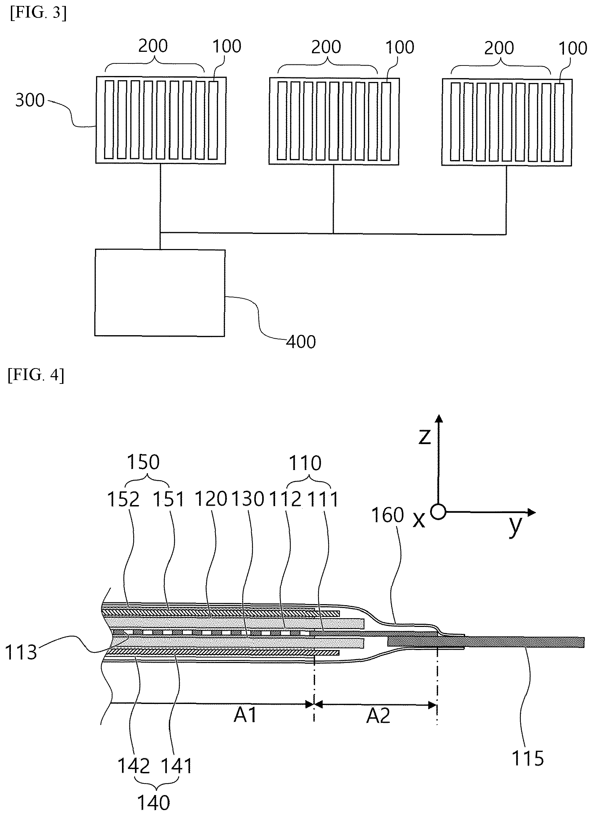

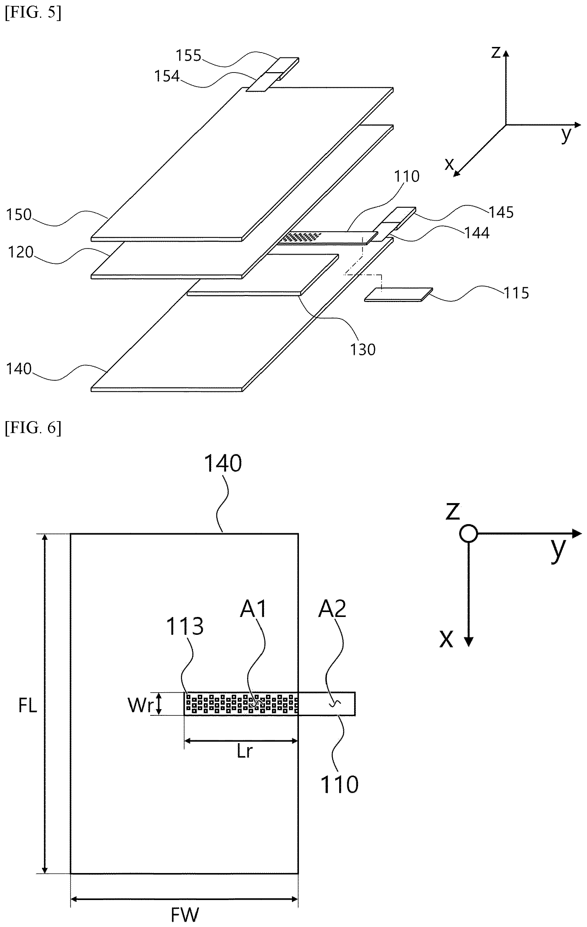

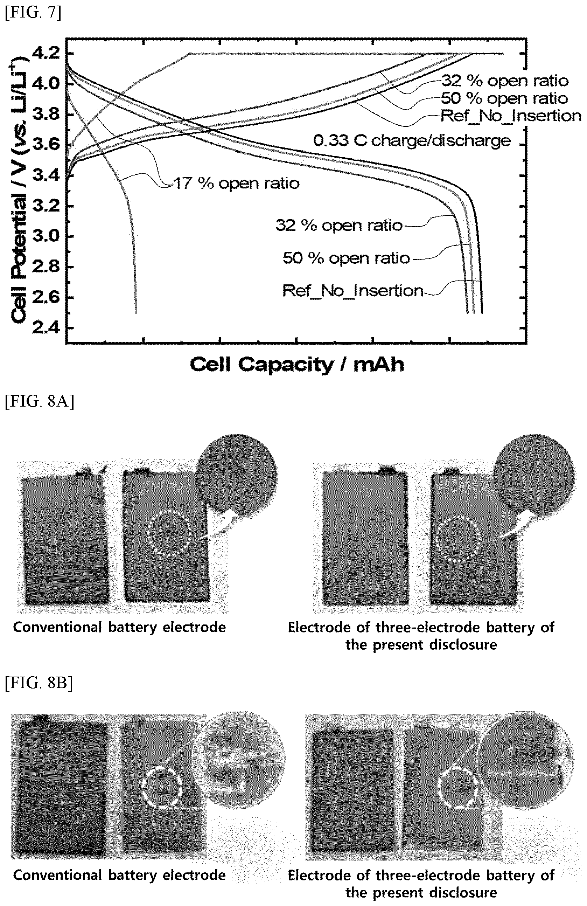

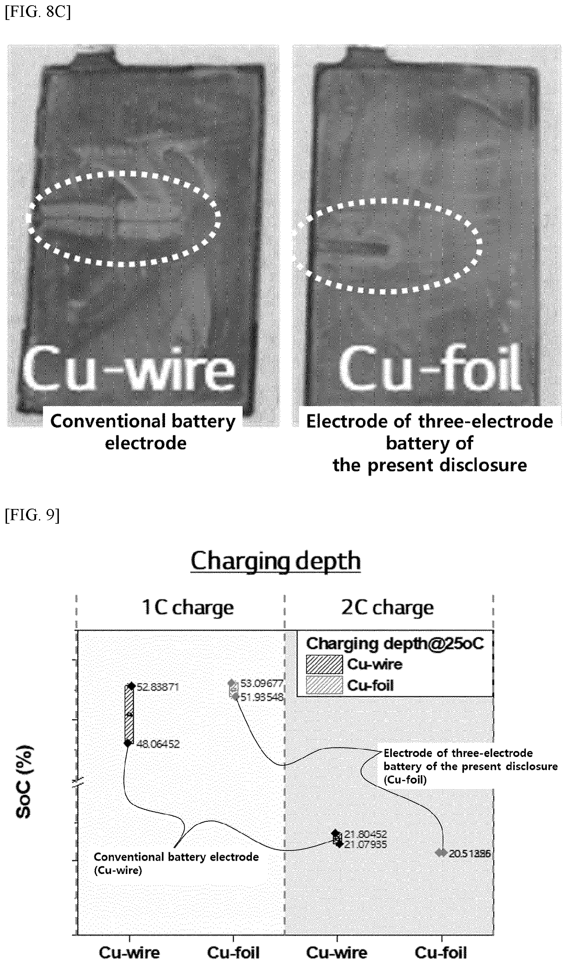

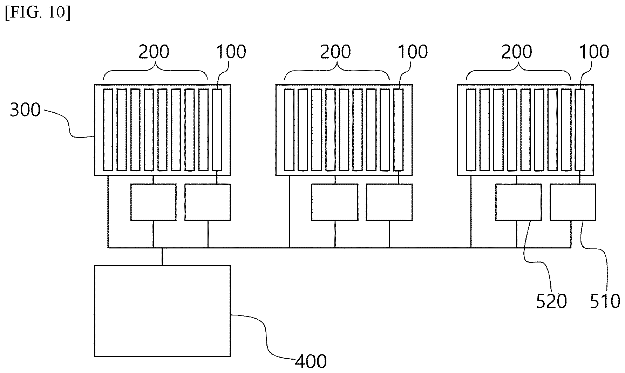

FIG. 3 is a block diagram illustrating a power supply device of the present disclosure. FIG. 4 is a cross-sectional view illustrating a three-electrode battery. FIG. 5 is an exploded perspective view illustrating a stacked structure of the three-electrode battery. FIG. 6 is a plan view illustrating an arrangement relationship between a first electrode and a reference electrode. FIG. 7 is a graph illustrating battery characteristics according to an open ratio of a first area. FIGS. 8A to 8C are photographs, each of which shows a state of a battery electrode according to a reference electrode. FIGS. 9 is a graph illustrating charging depth at 1C charge and 2C charge. FIG. 10 is a block diagram illustrating another embodiment of a power supply device of the present disclosure.

Hereinafter, referring to FIGS. 3 to 10, the power supply device of the present disclosure will be described in detail. In the xyz coordinate system shown in FIGS. 4 and 6, the x-axis direction may be a first direction, the y-axis direction may be a second direction, and the z-axis direction may be a vertical direction.

As shown in FIGS. 3 and 4, the power supply device of the present disclosure may include:
a battery module 300 provided with a plurality of secondary batteries 200; and
a battery management system (BMS) unit 400 configured to control the battery module 300,
wherein at least one of the plurality of secondary batteries 200 may be provided as a three-electrode battery 100 equipped with a reference electrode 110, and
wherein the reference electrode of the three-electrode battery 100 may be provided in a film shape in which a plurality of perforated holes 113 are formed.

The battery module 300 is provided as a set of a plurality of secondary batteries 200, and in a state in which the plurality of secondary batteries 200 are electrically connected to each other, it may be accommodated in a housing so that the plurality of secondary batteries 200 are fixed to each other so as not to be shaken by shock or vibration. Within the battery module 300, the plurality of secondary batteries 200 may be connected in series with each other. The three-electrode battery 100 may be one or a part of a plurality of secondary batteries 200 provided in the battery module 300. If necessary, all of the plurality of secondary batteries 200 provided in the battery module 300 may be provided as three-electrode batteries 100. In the power supply device of the present disclosure, the secondary battery 200 may be various types of batteries. For example, the secondary battery 200 and the three-electrode battery 100 may be pouch-type batteries.

The power supply device of the present disclosure may further include a cooling circuit (not shown) controlled by the BMS unit 400 and controlling the temperature of the battery module.

The battery management system (BMS) unit 400 may monitor specific values such as voltage (individual voltage of secondary battery or three-electrode battery, total voltage of battery module, minimum or maximum voltage of secondary battery, etc.) value, current (charging or discharging current, etc.), temperature (individual temperature of secondary battery, average temperature of battery module, additional cooling circuit inlet or outlet temperature, flow rate flowing in cooling circuit, etc.) value, SoC value, SoH value, depth of discharge value, and the like. In addition, the BMS unit 400 may perform at least one of voltage control (charging voltage, over-discharging voltage, etc.), current control (over-current, charging current, discharging current, etc.), output limit (output control through current control and voltage control, etc.), temperature control (cooling circuit control, etc.), cell balancing (frequency converter - PWM-inverter), SoC control and cell protection (control of a storage battery operating point to absorb regenerative braking energy without reaching an overcharge state) and relay control.

As shown in FIG. 4, the three-electrode battery 100 of the power supply device of the present disclosure may include:
a main separator 120;
the reference electrode 110 in the film shape stacked on one side surface of the main separator 120;
an auxiliary separator 130 stacked on the one side surface of the main separator 120 with the reference electrode 110 interposed therebetween;
a first electrode 140 and a second electrode 150 stacked with the main separator 120, the reference electrode 110, and the auxiliary separator 130 interposed therebetween; and
a battery case 160 in which the main separator 120, the reference electrode 110, the auxiliary separator 130, the first electrode 140, and the second electrode 150 are accommodated in an inner space.

The reference electrode 110 may be provided with a thickness of 45 µm to 120 µm. The thickness of the reference electrode 110 may be determined in consideration of a lifting phenomenon between the first electrode 140 and the second electrode 150, a dent phenomenon caused by shock or vibration applied to the three-electrode battery 100, and the like.

One of the first electrode 140 and the second electrode 150 may be formed as an cathode, and the other may be formed as an anode.

As shown in FIG. 4 and 5, the first electrode 140 may includea first electrode current collector 141, a first electrode active material 142 applied to the surface of the first electrode current collector 141, a first electrode tab 144 welded to an uncoated part of the first electrode current collector 141 on which the first electrode active material 142 is not coated, and a first electrode lead 145 having one end welded to the first electrode tab 144 inside the battery case 160 and the other end protruding out of the battery case 160. The second electrode 150 may also include a second electrode current collector 151, a second electrode active material 152 applied to the surface of the second electrode current collector 151, a second electrode tab 154 welded to an uncoated part of the second electrode current collector 151 on which the second electrode active material 152 is not coated, and a second electrode lead 155 having one end welded to the second electrode tab 154 inside the battery case 160 and the other end protruding out of the battery case 160.

The material of the main separator 120 and the auxiliary separator 130 may include at least one of ethylene homopolymer, propylene homopolymer, ethylene/butene copolymer, ethylene/hexene copolymer, and ethylene/methacrylate copolymer.

The main separator 120 may be located between the first electrode 140 and the second electrode 150.

The main separator 120, the first electrode 140, and the second electrode 150 may each be provided in plural, and in this case, the auxiliary separator 130 and the reference electrode 110 may be provided in one of the plurality of main separators 120.

Each of the main separator 120, the first electrode 140, and the second electrode 150 may be provided in a sheet shape and stacked so as to cross each other.

The auxiliary separator 130 may be formed in a size capable of covering the reference electrode 110 so that the reference electrode 110 does not directly contact the first electrode 140 or the second electrode 150.

As shown in FIGS. 4 and 5, the three-electrode battery of the power supply device of the present disclosure may be completed by injecting the electrolyte together with the electrode assembly formed by stacking the first electrode 140, the main separator 120, the reference electrode 110, the auxiliary separator 130, and the second electrode 150 in this order, or the first electrode 140, the auxiliary separator 130, the reference electrode 110, the main separator 120, and the second electrode 150 in this order, into the battery case 160 and then sealing the battery case 160.

At this time, when the first electrode 140 and the second electrode 150 are provided in plural numbers, the first electrode tab 144 welded to each of the plurality of first electrodes 140 is welded to one first electrode lead 145, and the second electrode tab 154 welded to each of the plurality of second electrodes 150 is welded to one second electrode lead 155, and one end of the first electrode lead 145 and one end of the second electrode lead 155 may protrude out of the battery case 160.

As shown in FIGS. 5 and 6, the reference electrode 110 may include a first area A1 facing the first electrode 140 or the second electrode 150, and a second area A2 protruding from one side of the first electrode 140 or the second electrode 150, wherein the plurality of perforated holes 113 are formed in the first area A1. In other words, the first area A1 may be used to establish a standard for the potential applied to the first electrode 140 or the second electrode 150, and the second area A2 may be used for electrical connection.

In the three-electrode battery 100 of the power supply device of the present disclosure, the reference electrode 110 may have a plurality of perforated holes 113 formed therein. By forming a plurality of perforated holes 113 in the reference electrode 110, it is possible to prevent the reference electrode 110 from interfering with the movement of ions between the first electrode 140 and the second electrode 150 and suppress the formation of a blocking area. An open ratio formed by the plurality of perforated holes 113 in the first area A1 may be 30% to 70%. In other words, the total area of the plurality of perforated holes 113 may be formed to be 30% to 70% of the area of the first area A1. When the open ratio is 30% or less in the first area A1, ion diffusion may not be smooth, and when it is 70% or more, the reference electrode may be broken. Therefore, the open ratio formed by the plurality of perforated holes 113 in the first area A1 may be preferably 30% to 70%.

FIG. 7 is a graph illustrating battery characteristics according to the open ratio of a first area. Specifically, it is a graph showing battery characteristics according to the open ratio of a test foil, for the battery including an electrode assembly in which a cathode, a separator, and an anode are stacked in this order, and a test foil having a perforated hole is inserted between the separator and the anode. Four batteries were prepared, and test foils having open ratio of 17%, 32%, and 50% were inserted into three batteries, respectively, and the test foil was not inserted into the remaining one battery. As shown in FIG. 7, it can be seen that the battery provided with the test foil of less than 30% open ratio (17% open ratio) appear to have impaired ion movement, whereas the battery provided with the test foil of 30% or more open ratio (32% and 50% open ratio) exhibits behavior similar to that of the secondary battery without the test foil itself.

The three-electrode battery 100 of the power supply device of the present disclosure may further include a reference electrode lead 115 having one end fused to the second area A2 of the reference electrode 110 and the other end protruding out of the battery case 160. Since the reference electrode 110 may be formed of a thin metal film or foil, fusion for sealing the battery case 160 or minimum stiffness for connection with an external electric terminal may not be secured. Accordingly, the reference electrode lead 115, which is a conductor for electrical connection, may be connected to the reference electrode 110, and the reference electrode lead 115 may be welded to the second area A2.

In the power supply device of the present disclosure, an area of the first area A1 may be provided as 1% to 10% of an area of the first electrode 140 or the second electrode 150. When the first area A1 of the reference electrode 110 is formed with an area exceeding 10%, lithium ion diffusion resistance may increase.

Specifically, as shown in FIG. 6, the first electrode 140 or the second electrode 150 may be provided in a rectangular shape having first and second directions orthogonal to each other as corners. More specifically, the length of the first electrode 140 or the second electrode 150 in the first direction may be formed to be longer than the length in the second direction.

At this time, the length Wr of the first area A1 in the first direction may be formed to be 1% to 3% of the length FL of the first electrode 140 or the second electrode 150 in the first direction, and the length Lr of the first area A1 in the second direction may be formed to be 5% to 95% of the length Fw of the first electrode 140 or the second electrode 150 in the second direction. The length Lr of the first area A1 in the second direction may be determined in consideration of specifications, materials, number of layers, and types of layers of the first electrode or the second electrode.

In other words, the reference electrode 110 may be provided in a shape extending in a direction perpendicular to the longitudinal direction of the first electrode 140 or the second electrode 150.

As shown in FIGS. 5 and 6, the reference electrode 110 may include a foil member 111 forming a body, and a reference electrode active material 112 coated on the foil member 111. The reference electrode active material 112 may be applied to the first area A1, and the second area A2 may be formed as an uncoated part on which the reference electrode active material 112 is not applied. For example, the width of the first area A1 and the second area A2 in the first direction may be formed to be 2 mm, and the length in the second direction may be formed to be 15 mm for the first area A1 and 3 mm for the second area A2.

The material of the foil member 111 may include at least one of Cu-foil and Al-foil, and the reference electrode active material 112 may be selected from the group consisting of LTO (Li4Ti5O12), LFP (LiFePO4), Li metal, and combinations thereof.

FIGS. 8A and 8C are photographs of electrode surfaces in the battery when the reference electrode 110 of the three-electrode battery applied to the power supply device of the present disclosure is applied and when the conventional wire-type reference electrode is applied. In each of FIGS. 8A and 8C, the conventional wire-type reference electrode is applied on the left of the drawing, and the reference electrode 110 of the present disclosure is applied on the right of the drawing.

FIG. 8A is an electrode extracted from a battery with 100% state of charge (SoC). It may be seen that unreacted regions are observed in the conventional type, but unreacted regions are not observed in the electrodes of the three-electrode battery applied to the power supply device of the present disclosure.

FIG. 8B is an electrode extracted from a battery subjected to 1C/1C, 20 cycles of charging and discharging. In the conventional type, it may be seen that Li precipitation is nonuniform in the vicinity of the wire-type reference electrode.

FIG. 8C is a photograph extracted from a battery to which fast charge is applied. In the conventional type, precipitation deepening occurs in the area adjacent to the wire-type reference electrode, but it may be seen that in the electrode of the three-electrode battery applied to the power supply device of the present disclosure, precipitation in the area adjacent to the reference electrode 110 is alleviated.

FIGS. 9 is a graph illustrating charging depth at 1C charge and 2C charge. It may be seen that the three-electrode battery applied to the power supply device of the present disclosure has a reduced charging depth deviation than the conventional battery.

The power supply device of the present disclosure may further include a first voltage measuring unit configured to measure a voltage between the reference electrode and the first electrode or the second electrode; and a second voltage measuring unit configured to measure a voltage of the battery module, wherein measured values of the first voltage measuring unit and the second voltage measuring unit are transferred to the BMS unit.

As another embodiment, as shown in FIG. 10, the power supply device of the present disclosure may further include a first voltage measuring unit 510 configured to measure a voltage between the reference electrode 110 and the first electrode 140 or the second electrode 150 and a second voltage measuring unit 520 configured to measure a voltage of the battery module 300, and measured values of the first voltage measuring unit 510 and the second voltage measuring unit 520 may be transferred to the BMS unit 400.

A plurality of the battery modules 300 may be provided, wherein each of the plurality of battery modules 300 may be provided with at least one or more three-electrode batteries 100, a plurality of the first voltage measuring units 510 may be provided, and a plurality of the second voltage measuring units 520 may be provided, wherein each of the plurality of battery modules 300 may be provided with at least one or more of the first voltage measuring units 510 and at least one or more of the second voltage measuring units 520.

Although embodiments according to the present disclosure have been described above, they are only illustrative and those skilled in the art will understand that various modifications and embodiments of equivalent range are possible therefrom. Therefore, the true technical protection scope of the present disclosure should be defined by the following claims.

<Explanation of Symbols> 100...Three-electrode battery, 110 ... Reference electrode, 111...Foil member, 112...Reference electrode active material, 113...Perforated hole, 115...Reference electrode lead, 120...Main separator, 130...Auxiliary separator, 140...First electrode, 141...First electrode current collector, 142...First electrode active material, 144...First electrode tab, 145...First electrode lead, 150...Second electrode, 151...Second electrode current collector, 152...Second electrode active material, 154...Second electrode tab, 155...Second electrode lead, 160...Battery case, 200...Secondary battery, 300...Battery module, 400...BMS unit, 510...First voltage measuring unit, 520...Second voltage measuring unit, A1...First area, A2...Second area

### Industrial Applicability

The power supply device of the present disclosure may be capable of monitoring the state of the secondary battery in real time by including a three-electrode battery which may be stably driven even when used for a long time or for multiple cycles.

The three-electrode battery in the power supply device of the present disclosure may minimize the area of the blocking area due to the reference electrode, and suppress the occurrence of circuit problems such as internal short circuit or electrode damage such as electrode pitting due to changes in battery internal pressure.

The three-electrode battery in the power supply device of the present disclosure may be capable of highly reliable monitoring of cathode/anode regardless of the electrode's own physical properties and whether or not it is driven.

The three-electrode battery in the power supply device of the present disclosure may be a Si/SiO battery with a large thickness change, or a monitoring for long-term deterioration may be advantageous for it.

In the three-electrode battery in the power supply device of the present disclosure, the effect of reducing the three-electrode deviation may be expected due to the reduction of the blocking area.

The three-electrode battery in the power supply device of the present disclosure has a structure that facilitates design of a medium or large-sized battery, and may be applied regardless of the stack or area of the electrode.

## Claims

1. A power supply device comprising:
a battery module provided with a plurality of secondary batteries; and
a battery management system (BMS) unit configured to control the battery module,
wherein at least one of the plurality of secondary batteries is provided as a three-electrode battery equipped with a reference electrode, and
the reference electrode of the three-electrode battery is provided in a film shape in which a plurality of perforated holes are formed.

2. The power supply device of claim 1, wherein the three-electrode battery comprises:
a main separator;
the reference electrode in the film shape stacked on one side surface of the main separator;
an auxiliary separator stacked on the one side surface of the main separator with the reference electrode interposed therebetween;
a first electrode and a second electrode stacked with the main separator, the reference electrode, and the auxiliary separator interposed therebetween; and
a battery case in which the main separator, the reference electrode, the auxiliary separator, the first electrode, and the second electrode are accommodated in an inner space, and
the reference electrode is provided with a thickness of 45 µm to 120 µm.

3. The power supply device of claim 2, wherein the reference electrode comprises:
a first area facing the first electrode or the second electrode; and
a second area protruding from one side of the first electrode or the second electrode, and
wherein the plurality of perforated holes are formed in the first area, and
an open ratio formed by the plurality of perforated holes in the first area is 30% to 70%.

4. The power supply device of claim 3, wherein the three-electrode battery further comprises a reference electrode lead having one end fused to the second area of the reference electrode and the other end protruding out of the battery case.

5. The power supply device of claim 3, wherein an area of the first area is provided as 1% to 10% of an area of the first electrode or the second electrode.

6. The power supply device of claim 1, wherein the reference electrode comprises:
a foil member forming a body; and
a reference electrode active material coated on the foil member.

7. The power supply device of claim 6, wherein a material of the foil member comprises at least one of Cu-foil and Al-foil.

8. The power supply device of claim 6, wherein the reference electrode active material is selected from a group consisting of LTO (Li4Ti5O12), LFP (LiFePO4), Li metal, and combinations thereof.

9. The power supply device of claim 2, further comprising:
a first voltage measuring unit configured to measure a voltage between the reference electrode and the first electrode or the second electrode; and
a second voltage measuring unit configured to measure a voltage between the first electrode and the second electrode,
wherein measured values of the first voltage measuring unit and the second voltage measuring unit are transferred to the BMS unit.

10. The power supply device of claim 2, further comprising:
a first voltage measuring unit configured to measure a voltage between the reference electrode and the first electrode or the second electrode; and
a second voltage measuring unit configured to measure a voltage of the battery module,
wherein measured values of the first voltage measuring unit and the second voltage measuring unit are transferred to the BMS unit.

11. The power supply device of claim 10, wherein a plurality of the battery modules are provided, and
each of the plurality of battery modules is provided with at least one three-electrode battery,
wherein a plurality of the first voltage measuring units are provided, and
a plurality of the second voltage measuring units are provided, and
wherein each of the plurality of battery modules is provided with at least one or more of the first voltage measuring units and at least one or more of the second voltage measuring units.
